Europäisches Patentamt

European Patent Office

Office européen des brevets

(11) Veröffentlichungsnummer: **0 454 946 A1**

## (12) EUROPÄISCHE PATENTANMELDUNG

(21) Anmeldenummer: 91100885.2

(22) Anmeldetag: 24.01.91

(51) Int. Cl.⁵: **G01R 19/00**

(30) Priorität: 03.05.90 CH 1503/90

(43) Veröffentlichungstag der Anmeldung:
**06.11.91 Patentblatt 91/45**

(84) Benannte Vertragsstaaten:
**CH DE ES FR GB GR IT LI NL SE**

(71) Anmelder: **Landis & Gyr Betriebs AG**
**CH-6301 Zug(CH)**

(72) Erfinder: **Gruber, Peter**
**Am Hofibach 9**
**CH-8909 Zwillikon(CH)**
Erfinder: **Tödtli, Jürg**
**Hardeggstrasse 21a**
**CH-8049 Zürich(CH)**

(54) **Verfahren zur Ermittlung von Schätzwerten der Momentanwerte von Parametern mindestens eines sinusförmigen Signals mit konstanter und vorbekannter Frequenz, welches ein additiver Teil eines Messsignals ist.**

㉗ Momentanwerte $y[k]$ des Messsignals $y[t]$ werden mittels einer Abtastschaltung (1) erzeugt, mittels eines Analog/Digital-Wandlers (1a) in digitale Werte umgewandelt und in einer Speicherschaltung (2) gespeichert, so dass sie zu diskreten Zeitpunkten (k) zur Verfügung stehen. In einem Estimator (3) werden anschliessend aus ihnen Schätzwerte ($a_{0,e}[k]$, $a_{n,e}[k]$, $b_{n,e}[k]$, mit $n = 1,2,...,L$) der Momentanwerte von Fourier-Koeffizienten von mindestens zwei gesuchten sinusförmigen Signalen, die verschiedene, zum voraus bekannte Frequenzen besitzen, ermittelt und gespeichert. Aus den gespeicherten Schätzwerten werden zeitlich nacheinander Differenzsignale zwischen gemessenen Momentanwerten ($y[k]$) und rekonstruierten Momentanwerten des Messsignals ($y[t]$) erzeugt, die anschliessend dazu dienen, die gespeicherten Schätzwerte schrittweise zu korrigieren. Die korrigierten Schätzwerte können dann noch in einem Tiefpassfilter (4) gefiltert werden und die gefilterten Schätzwerte ($a_{0,e,m}[kT_s]$, $a_{n,e,m}[kT_s]$, $b_{n,e,m}[kT_s]$) anschliessend in einer Transformationsschaltung (5) mittels einer nichtlinearen Transformation in Schätzwerte ($A_{0,e}[kT_s]$, $A_{n,e}[kT_s]$, $\Phi_{n,e}[kT_s]$) von Momentanwerten der Amplituden und/oder Phasen von gesuchten sinusförmigen Signalen umgewandelt werden. Das Tiefpassfilter (4) und die Transformationsschaltung (5) können mit einem langsameren Taktsignal $C_{L,s}$ betrieben werden, welches eine Taktperiode $T_s$ besitzt, die ein Vielfaches der Periode des

Taktsignals $C_L$ der restlichen Anordnung ist.

Fig. 1

Die Erfindung bezieht sich auf ein Verfahren zur Ermittlung von Schätzwerten der Momentanwerte von Parametern mindestens eines sinusförmigen Signals mit konstanter und vorbekannter Frequenz, welches ein additiver Teil eines Messsignals ist, gemäss dem Oberbegriff des Anspruchs 1, auf eine Anordnung zur Durchführung des Verfahrens und auf Verwendungen des Verfahrens und/oder der Anordnung.

Solche Verfahren und Anordnungen werden vorteilhaft verwendet in Nachrichten-Übertragungseinrichungen und/oder in Messeinrichtungen, in denen jeweils neben einem zu ermittelnden Nutzsignal noch mindestens ein sinusförmiges Störsignal bekannter Frequenz vorhanden ist, dessen unbekannte Parameterwerte, d. h. die Werte von Fourier-Koeffizienten oder von Amplitude und/oder Phase, mindestens schätzungsweise ebenfalls ermittelt werden sollen.

Die oben erwähnten Messeinrichtungen sind z. B. vorzugsweise Elektrizitätszähler und dienen dann der Messung einer elektrischen Energie oder Leistungsmessgeräte und dienen dann der Messung einer elektrischen Leistung. Je nach Ausführungsvariante werden in diesem Fall mit dem erfindungsgemässen Verfahren und/oder der erfindungsgemässen Anordnung Werte einer elektrischen Wirkenergie und/oder einer elektrischen Blindenergie und/oder einer elektrischen Scheinenergie bzw. Werte einer elektrischen Wirkleistung und/oder einer elektrischen Blindleistung und/oder einer elektrischen Scheinleistung bestimmt. Da in einem elektrischen Energieversorgungsnetz in der Regel neben einem Netzfrequenzsignal, welches eine 50Hz- oder 60Hz-Frequenz aufweist, auch harmonische Oberwellensignale dieses Netzfrequenzsignals vorhanden sind, ermittelt ein zugehöriger Wechselstrom-Elektrizitätszähler oder ein zugehöriges Wechselstrom-Leistungsmessgerät nicht nur die Energie bzw. Leistung des Netzfrequenzsignals, sondern auch diejenige der harmonischen Oberwellensignale. Der Elektrizitätszähler und das Leistungsmessgerät enthält dann jeweils ein nachfolgend einfachshalber als auszuwertendes Messsignal bezeichnetes Signal, welches gleich der Summe der Energien bzw. Leistungen des Netzfrequenzsignals und der Oberwellensignale ist, deren Anteile jeweils mindestens teilweise mittels des erfindungsgemässen Verfahrens und/oder der erfindungsgemässen Anordnung ermittelt werden können.

In den erwähnten Messeinrichtungen können jedoch auch zusätzlich oder allein Effektivwerte von Strömen und/oder elektrischen Spannungen des Netzfrequenzsignals und der Oberwellensignale mittels des erfindungsgemässen Verfahrens und/oder der erfindungsgemässen Anordnung bestimmt werden.

Die oben erwähnten Nachrichten-Übertragungseinrichtungen sind z. B. vorzugsweise auch Rundsteuerungsanlagen ("ripple control installations"), in denen bekanntlich Informationen mittels eines als Nutzsignal verwendeten modulierten sinusförmigen Trägersignals über ein elektrisches Energieversorgungsnetz übertragen werden. Das Trägersignal ist dabei z. B. impulsamplitudenmoduliert. Das gesendete Nutzsignal wird im elektrischen Energieversorgungsnetz gestört durch das Netzfrequenzsignal des elektrischen Energieversorgungsnetzes, welches eine 50Hz- oder 60Hz-Frequenz aufweist, und durch harmonische Oberwellensignale des Netzfrequenzsignals sowie in der Regel auch noch durch Rauschen ("noise") und andere Rundsteuerungssignale. Das erfindungsgemässe Verfahren und/oder die erfindungsgemässe Anordnung wird in der Rundsteuerungsanlage verwendet zur Detektion von gesendeten Rundsteuerungssignalen. In einem Rundsteuerungs-Empfänger muss dann das gesendete und übertragene modulierte sinusförmige Rundsteuerungs-Nutzsignal aus einem Messsignal ermittelt werden, welches aus der Summe des Nutzsignals, des sinusförmigen Netzfrequenzsignals, einer Vielzahl sinusförmiger harmonischer Oberwellensignale des Netzfrequenzsignals, des Rauschens und modulierter sinusförmiger Trägersignale anderer Rundsteuerungssignale besteht, welche letztere alle als Störsignale dem Nutzsignal additiv überlagert sind. Die Frequenzen der sinusförmigen Störsignale und des Trägersignals des Nutzsignals sind im voraus bekannt, während die Amplitude und/oder Phase des Nutzsignals sowie die Amplituden und/oder Phasen aller oder eines Teils der Störsignale mittels des erfindungsgemässen Verfahrens und/oder der erfindungsgemässen Anordnung ermittelt werden können.

Das erfindungsgemässe Verfahren und/oder die erfindungsgemässe Anordnung können jedoch auch dazu benutzt werden, gleichzeitig Rundsteuerungssignale und eine elektrische Wirkleistung und/oder Blindleistung und/oder Scheinleistung bzw. -energie zu bestimmen.

In allen Verwendungsbeispielen sind die Werte der Amplituden und Phasen der sinusförmigen Signale sowie eines oft vorhandenen Gleichspannungsanteils in der Regel eine Funktion der Zeit t.

Ein Verfahren der im Oberbegriff des Anspruchs 1 genannten Art ist aus der Druckschrift "Signal Processing IV, Theory and Applications, EUSIPCO 88, Grenoble, France, EURASIP, North Holland, A recursive estimator for the determination of unknown constant or slowly varying Fourier coefficients, P. Gruber, J. Toedtli, pages 1433 bis 1436" bekannt. In dem dort beschriebenen Verfahren kann ein sinusförmiges Signal mit bekannter Frequenz, dessen Amplitude und/oder Phase zeitlich variiert, und welches additiver Teil eines Messsignals ist, in Echtzeit mindestens schätzungsweise ermittelt werden.

Der Erfindung liegt die Aufgabe zugrunde, das bekannte Verfahren zu verbessern und/oder wesentlich zu erweitern, so dass mindestens ein weiteres im Messsignal enthaltenes sinusförmiges Signal bekannter Frequenz, dessen Amplitude und/oder Phase zeitlich variieren können, mindestens schätzungsweise ermittelt werden kann, was u.a. den Vorteil hat, dass die ermittelten Werte der Amplituden und/oder Phasen der zu ermittelnden sinusförmigen Signale sowie die ermittelten Werte eines zu ermittelnden Gleichspannungsanteils in der Regel genauer sind.

Da das erfindungsgemässe Verfahren, ohne zusätzlichen grossen Aufwand, auch Parameter aller anderen vorhandenen sinusförmigen Signale mindestens schätzungsweise ermitteln kann, ist der Vorteil vor allem in jenen Anwendungen besonders gross, in denen mehr als ein sinusförmiges Signal zu identifizieren sind, z. B. ein sinusförmiges Nutzsignal und ein sinusförmiges Störsignal oder zwei sinusförmige Störsignale.

Ist einmal bekannt, dass ein Messsignal aus M sinusförmigen Signalen besteht, die alle eine vorbekannte, konstante und unterschiedliche Frequenz besitzen, und sollen die möglicherweise variierenden Amplituden und Phasen einer Vielzahl dieser M sinusförmigen Signale mindestens schätzungsweise ermittelt werden, so liefert das erfindungsgemässe Verfahren mit nur geringem Mehraufwand genauere Werte als das aus dem Stand der Technik bekannte Verfahren, wenn letzteres getrennt auf jedes einzelne der Vielzahl sinusförmiger Signale angewendet würde.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:

Fig. 1 ein Blockschaltbild einer Anordnung zur Durchführung des erfindungsgemässen Verfahrens,

Fig. 2 ein Blockschaltbild eines Signalmodells, welches für einen Entwurf eines optimalen Estimators verwendet wird, und

Fig. 3 ein Blockschaltbild eines Estimators.

Gleiche Bezugszahlen bezeichnen in allen Figuren der Zeichnung gleiche Teile.

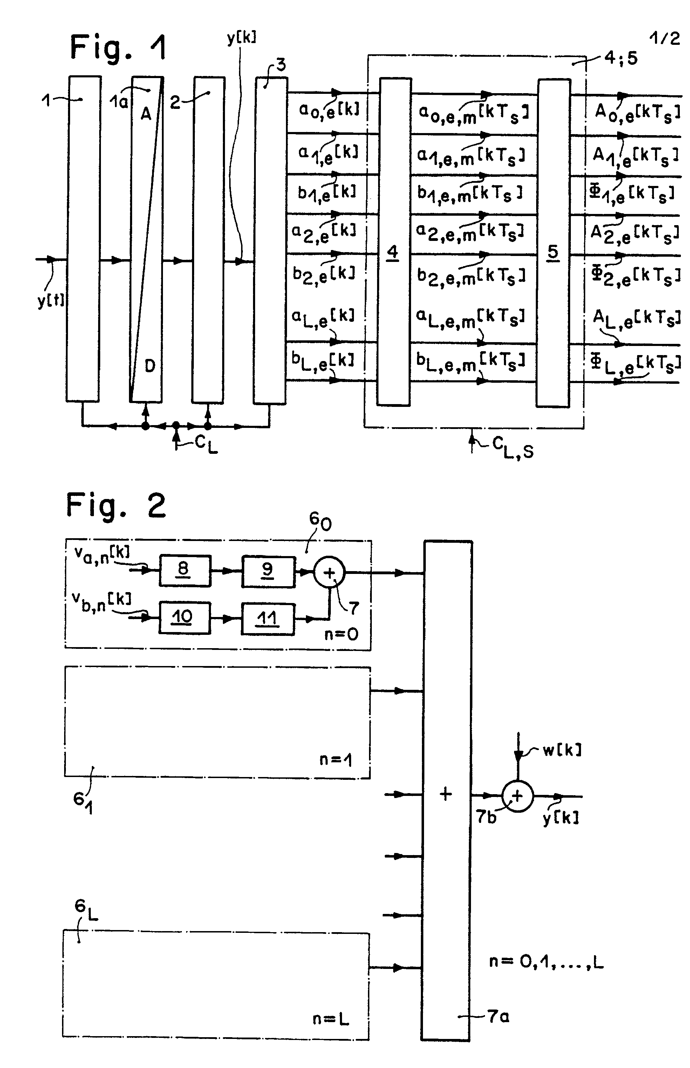

Ein Eingang der in der Fig. 1 dargestellten Anordnung zur Durchführung des Verfahrens wird von einem auszuwertenden Messsignal y[t] gespeist, welches eine Funktion der Zeit t ist, und die Anordnung selber besteht aus einer Abtastschaltung 1, einem Analog/Digital-Wandler 1a, einer Speicherschaltung 2, einem Estimator 3 und einer fakultativ vorhandenen Nachverarbeitungsanordnung 4;5, die in der angegebenen Reihenfolge in Kaskade geschaltet sind. Der Analog/Digital-Wandler 1a ist somit zwischen der Abtastschaltung 1 und der Speicherschaltung 2 angeordnet. Ausser der Nachverarbeitungsanordnung 4;5 werden alle Bauelemente der Anordnung mit einem relativ schnellen Taktsignal $C_L$ gespeist. Die Nachverarbeitungsanordnung 4;5 kann ihrerseits mit dem Taktsignal $C_L$ oder, wie in der Fig. 1 angedeutet, mit einem langsameren Taktsignal $C_{L,s}$ gespeist werden.

Die Nachverarbeitungsanordnung 4;5 besteht ihrerseits vorzugsweise aus einem fakultativ vorhandenen Tiefpassfilter 4 und/oder einer fakultativ vorhandenen Transformationsschaltung 5, die, wenn beide vorhanden, in der angegebenen Reihenfolge in Kaskade geschaltet sind. Das Tiefpassfilter 4 ist somit, falls vorhanden, dem Estimator 3 nachgeschaltet und die Transformationsschaltung 5, falls vorhanden, am Ausgang der erfindungsgemässen Anordnung angeordnet.

Nachfolgend gilt die Annahme, dass die erfindungsgemässe Anordnung in digitaler Weise und dass das Messsignal y[t] sich

- aus einem "Gleichspannungsanteil" $a_0[t]$,
- aus M periodischen sinusförmigen Signalen und
- einem Rauschsignal w[t]

additiv zusammensetzt, wobei die Amplituden und die Phasen der M sinusförmigen Signale sowie der "Gleichspannungsanteil" $a_0[t]$ alle zeitlich variabel sein können. Nachfolgend gilt die Annahme, dass die M sinusförmigen Signale mit einem Index n gekennzeichnet sind und dass sie, bei n = 1 beginnend, fortlaufend durchgehend bis n = M numeriert sind.

Als sinusförmige Signale im Sinne der Erfindung gelten Signale, deren Werte eine Sinus- oder eine phasenverschobene Sinusfunktion der Zeit t sind. Da mathematisch betrachtet der "Gleichspannungsanteil" $a_0[t]$ eine Cosinusfunktion der Zeit t ist, dessen Frequenz und Phase Null sind und dessen Amplitude $A_0[t]$ gleich dem Wert $a_0[t]$ des "Gleichspannungsanteils" ist, ist der "Gleichspannungsanteil" $a_0[t]$ ebenfalls ein sinusförmiges Signal im Sinne der Erfindung, dem nachfolgend ein Index n = 0 zugeordnet wird.

Das Messsignal y[t] wird mit Hilfe der am Eingang der Anordnung vorhandenen Abtastschaltung 1 zu diskreten Zeitpunkten $t_k$ abgetastet. Vorzugsweise erfolgt die Abtastung zu äquidistanten Zeitpunkten mit einer konstanten zeitlichen Abtastperiode T, d. h. mit $t_k = k.T$. Die Variable k, mit k = 0,1,2,..., usw., bezeichnet dabei die laufende Nummer der Abtastungen, wenn diese, mit Null beginnend, fortlaufend durchgehend numeriert sind. Die Abtastperiode T ist gleich der Periode des Taktsignals $C_L$.

Die abgetasteten Analogwerte $y[t_k] = y[kT]$ des Messsignals $y[t]$ sind die gemessenen Momentanwerte des Messsignals $y[t]$ und werden nachfolgend einfachshalber mit $y[k]$ bezeichnet, wobei die Bezeichnung $[k]$ für die Bezeichnung $[kT]$ steht. Im Analog/Digital-Wandler 1a werden die gemessenen Momentanwerte $y[k]$ in proportionale Digitalwerte umgewandelt, die dann in der nachgeschalteten Speicherschaltung 2 gespeichert werden, um anschliessend den Eingang des Estimators 3 zu erreichen. Die gemessenen Momentanwerte $y[k]$ des Messsignals $y[t]$ stehen in jedem Fall zu den diskreten Zeitpunkten $t_k$ bzw. $kT$ bzw. $k$ zur Verfügung.

Es bedeuten, mit $n = 1,2,3,...,M$:

$\Omega_n$ : eine vorbekannte, konstante und zeitunabhängige Kreisfrequenz eines n-ten der M sinusförmigen Signale,

$A_n[k]$ : ein k-ter Momentanwert einer in der Regel zeitvariablen Amplitude des n-ten der M sinusförmigen Signale,

$\Phi_n[k]$ : ein k-ter Momentanwert einer in der Regel zeitvariablen Phase des n-ten der M sinusförmigen Signale,

$a_n[k]$ : ein k-ter Momentanwert eines ersten Fourier-Koeffizienten $a_n[t]$ des n-ten der M sinusförmigen Signale,

$b_n[k]$ : ein k-ter Momentanwert eines zweiten Fourier-Koeffizienten $b_n[t]$ des n-ten der M sinusförmigen Signale,

$a_0[k]$ : ein k-ter Momentanwert des "Gleichspannungsanteils" $a_0[t]$ und

$w[k]$ : ein k-ter Momentanwert des Rauschens $w[t]$.

Es gelten dann folgende Gleichungen:

$$a_n[k] = A_n[k].\sin\Phi_n[k] \qquad (II)$$
$$b_n[k] = A_n[k].\cos\Phi_n[k] \qquad (III)$$
$$y[k] = a_0[k] + \Sigma\{A_n[k].\sin(\Omega_n.k.T + \Phi_n[k])\} + w[k]$$
$$= a_0[k] + \Sigma\{a_n[k].\cos(\Omega_n.k.T) + b_n[k].\sin(\Omega_n.k.T)\} + w[k] \qquad (IV)$$

wobei $\Sigma\{...\}$ die Summe der Termen $\{...\}$ für alle Werte von $n = 1$ bis $n = M$ ist.

Die Momentanwerte $a_n[k]$ und $b_n[k]$ der Fourier-Koeffizienten $a_n[t]$ und $b_n[t]$ bzw. die Momentanwerte $A_n[k]$ und $\Phi_n[k]$ der Amplitude $A_n[t]$ und der Phase $\Phi_n[t]$ sind dabei in der Regel unbekannte, zeitlich variierende Parameter, die die n-te der M sinusförmigen Signale kennzeichnen. Die Momentanwerte $a_0[k] = A_0[k]$ des Fourier-Koeffizienten $a_0[t]$ des "Gleichspannungsanteils" bzw. der Amplitude $A_0[t]$ des entsprechenden sinusförmigen Signals mit dem Index 0, sind in der Regel ebenfalls unbekannte, zeitlich variierende Parameter, die den "Gleichspannungsanteil" bzw. das entsprechende sinusförmige Signal mit dem Index $n = 0$ kennzeichnen.

Das erfindungsgemässe Verfahren gestattet nun Momentanwerte $a_0[k]$, $a_n[k]$ und $b_n[k]$ bzw. $A_0[k]$, $A_n[k]$ und $\Phi_n[k]$ des "Gleichspannungsterms" $a_0[t]$ und von L der M sinusförmigen Signale schätzungsweise zu ermitteln, wobei L kleiner oder gleich M und mindestens gleich 1 ist. Ohne Einschränkung der Allgemeinheit wird nachfolgend angenommen, dass Parameter der L ersten dieser M sinusförmigen Signale und der Parameter $a_0[k]$ des "Gleichspannungsanteils" zu ermitteln sind, so dass immer mindestens Momentanwerte von Parametern zweier gesuchter sinusförmiger Signale schätzungsweise zu ermitteln sind, wenn der "Gleichspannungsanteil" $a_0[t]$ als sinusförmiges Signal mitgerechnet wird. Die Variable n besitzt nachfolgend immer die Werte $1,2,3,..., L$.

Das erfindungsgemässe Verfahren besteht nun darin, zuerst einmal zeitlich nacheinander fortlaufend Schätzwerte $a_{0,e}[k]$, $a_{n,e}[k]$ und $b_{n,e}[k]$ der Momentanwerte $a_0[k]$, $a_n[k]$ und $b_n[k]$ der Fourier-Koeffizienten für mindestens zwei gesuchte sinusförmige Signale zu ermitteln und zu speichern, die verschiedene, zum voraus bekannte Frequenzen besitzen. Zu diesem Zweck ist der Estimator 3 vorhanden. Die so ermittelten Schätzwerte $a_{0,e}[k]$, $a_{1,e}[k]$, $a_{2,e}[k]$, ... ,$a_{L,e}[k]$, $b_{1,e}[k]$, $b_{2,e}[k]$, ... , $b_{L,e}[k]$ dieser Fourier-Koeffizienten erscheinen am Ausgang des Estimators 3 und damit am Eingang der Nachverarbeitungsanordnung 4;5, falls diese vorhanden ist, wobei der Index "e" "estimated value", also Schätzwert bedeutet.

Da die so gefundenen Schätzwerte $a_{0,e}[k]$, $a_{n,e}[k]$ und $b_{n,e}[k]$ der Momentanwerte $a_0[k]$, $a_n[k]$ und $b_n[k]$ der Fourier-Koeffizienten Schwankungen unterworfen sein können, werden sie vorzugsweise im Tiefpassfilter 4 der Nachverarbeitungsanordnung 4;5 zuerst einmal gefiltert, so dass am Ausgang des Tiefpassfilters 4 nur Mittelwerte $a_{0,e,m}[k]$, $a_{1,e,m}[k]$, $a_{2,e,m}[k]$, ... ,$a_{L,e,m}[k]$, $b_{1,e,m}[k]$, $b_{2,e,m}[k]$, ... , $b_{L,e,m}[k]$ der Schätzungswerte $a_{0,e}[k]$, $a_{1,e}[k]$, $a_{2,e}[k]$, ... ,$a_{L,e}[k]$, $b_{1,e}[k]$, $b_{2,e}[k]$, ... , $b_{L,e}[k]$ erscheinen, wobei der Index "m" Mittelwert ("mean value") bedeutet.

Falls nur Schätzwerte $a_{0,e}[k]$, $a_{n,e}[k]$ und $b_{n,e}[k]$ der Momentanwerte $a_0[k]$, $a_n[k]$ und $b_n[k]$ der Fourier-Koeffizienten gesucht werden, dann ist die Transformationsschaltung 5 überflüssig, so dass sie weggelassen werden kann. Werden dagegen auch Schätzwerte $A_{n,e}[k]$ und $\Phi_{n,e}[k]$ der Momentanwerte $A_n[k]$ und $\Phi_n[k]$ der Amplituden und/oder Phasen der sinusförmigen Signale gesucht, dann wird auch die Transformationsschaltung 5 benötigt.

In der Transformationsschaltung 5 werden, je nach Ab- oder Anwesenheit des Tiefpassfilters 4, aus den nichtgefilterten bzw. gefilterten Schätzwer-

ten $a_{0,e}[k]$, $a_{n,e}[k]$ und $b_{n,e}[k]$ bzw. $a_{0,e,m}[kT_s]$, $a_{n,e,m}$-$[kT_s]$ und $b_{n,e,m}[kT_s]$ der Momentanwerte $a_0[k]$, $a_n[k]$ und $b_n[k]$ der Fourierkoeffizienten mittels einer nichtlinearen Transformation und der Gleichungen

$$A_{n,e}[k] = \sqrt{\{(a_{n,e,m}[k])^2 + (b_{n,e,m}[k])^2\}} \quad \text{(IV)und}$$
$$\Phi_{n,e}[k] = \text{arctg}\{a_{n,e,m}[k]/b_{n,e,m}[k]\} \quad \text{(V)},$$

die von den Gleichungen (II) und (III) abgeleitet sind, die Schätzwerte $A_{n,e}[k]$ und/oder $\Phi_{n,e}[k]$ der Momentanwerte $A_n[k]$ bzw. $\Phi_n[k]$ der Amplituden bzw. Phasen der gesuchten L sinusförmigen Signale sowie die Schätzwerte $A_{0,e}[k] = a_{0,e}[k]$ der Momentanwerte $A_0[k]$ der Amplitude des gesuchten, mit dem Index $n = 0$ versehenen sinusförmigen Signals ermittelt.

Falls die Schätzwerte am Eingang der Nachverarbeitungsanordnung 4;5 schneller als gefordert anfallen, können diese in der Nachverarbeitungsanordnung 4;5 verlangsamt werden, indem in der Nachverarbeitungsanordnung 4;5 das relativ schnelle Taktsignal $C_L$ durch das langsamere Taktsignal $C_{L,s}$ ersetzt wird. Die Nachverarbeitungsanordnung 4;5 wird dann, wie in der Fig. 1 angenommen, ausschliesslich mit dem langsameren Taktsignal $C_{L,s}$ gespeist. Die Periode $T_s$ des langsameren Taktsignals $C_{L,s}$ wird vorzugsweise gleich einem Vielfachen von T gewählt. In diesem Fall sind die am Ausgang des Tiefpassfilters 4 anstehenden Mittelwerte $a_{0,e,m}[k]$, $a_{1,e,m}[k]$, $a_{2,e,m}[k]$, ... ,$a_{L,e,m}[k]$, $b_{1,e,m}[k]$, $b_{2,e,m}[k]$, ... , $b_{L,e,m}[k]$ der Schätzwerte, in deren Bezeichnungen, wie bereits erwähnt, die Bezeichnung [k] für die Bezeichnung [kT] steht, durch die Mittelwerte $a_{0,e,m}[kT_s]$, $a_{1,e,m}[kT_s]$, $a_{2,e,m}[kT_s]$, ... ,$a_{L,e,m}[kT_s]$, $b_{1,e,m}[kT_s]$, $b_{2,e,m}[kT_s]$, ... , $b_{L,e,m}[kT_s]$ der Schätzwerte zu ersetzen (siehe Fig. 1). In der Transformationsschaltung 5 werden dann, ausgehend von den Mittelwerten $a_{0,e,m}[kT_s]$, $a_{1,e,m}[kT_s]$ bis $a_{L,e,m}[kT_s]$ und $b_{1,e,m}[kT_s]$ bis $b_{L,e,m}[kT_s]$ der Schätzwerte, mittels einer nichtlinearen Transformation und der Gleichungen

$$A_{n,e}[kT_s] = \sqrt{\{(a_{n,e,m}[kT_s])^2 + (b_{n,e,m}[kT_s])^2\}} \quad \text{(VI)}$$
und
$$\Phi_{n,e}[kT_s] = \text{arctg}\{a_{n,e,m}[kT_s]/b_{n,e,m}[kT_s]\} \quad \text{(VII)}$$

die gesuchten Schätzwerte $A_{n,e}[kT_s]$ der Amplituden $A_n[kT_s]$ und $\Phi_{n,e}[kT_s]$ der Phasen $\Phi_n[kT_s]$ der L sinusförmigen Signale sowie $A_{0,e}[kT_s] = a_{0,e}[kT_s]$ des Terms $a_0[kT_s]$ des "Gleichspannungsanteils" ermittelt, die dann am Ausgang der Transformationsschaltung 5 und damit am Ausgang der erfindungsgemässen Anordnung erscheinen. Die so ermittelten Schätzwerte erscheinen am Ausgang der Transformationsschaltung 5 und damit auch am Ausgang der erfindungsgemässen Anordnung.

Um die zeitlichen Variationen der Schätzwerte $a_{0,e}[k]$, $a_{n,e}[k]$ und $b_{n,e}[k]$ der Momentanwerte $a_0[k]$, $a_n[k]$ und $b_n[k]$ der Fourier-Koeffizienten ermitteln zu können, wird vorzugsweise ein statistisches Verfahren verwendet und dabei angenommen, dass die Schätzwerte $a_{0,e}[k]$, $a_{n,e}[k]$ und $b_{n,e}[k]$ mittels eines Signalmodells erzeugt werden, welches in der Fig. 2 dargestellt ist und eine zufällige Variation dieser Schätzwerte gestattet.

Das in der Fig. 2 dargestellte Signalmodell enthät $L + 1$ Schaltungen $6_n$, mit $n = 0, 1, ..., L$. Die Schaltungen $6_n$ sind alle gleich aufgebaut und bestehen je aus einem Addierer 7, einem ersten dynamischen Signalmodell 8, einem ersten Multiplizierer 9, einem zweiten dynamischen Signalmodell 10 und einem zweiten Multiplizierer 11, wobei jeweils der Ausgang des ersten dynamischen Signalmodells 8 über den ersten Multiplizierer 9 auf einen ersten Eingang des Addierers 7 und der Ausgang des zweiten dynamischen Signalmodells 10 über den zweiten Multiplizierer 11 auf einen zweiten Eingang des Addierers 7 geführt ist. Der Multiplikationsfaktor des ersten Multiplizierers 9 ist jeweils $\cos(\Omega_n.k.T)$ und derjenige des zweiten Multiplizierers 11 $\sin(\Omega_n.k.T)$. Ein Eingang des ersten dynamischen Signalmodells 8 der Schaltung $6_n$ wird dabei mit Momentanwerten $v_{a,n}[k]$ eines ersten Rauschsignals und ein Eingang des zweiten dynamischen Signalmodells 10 der Schaltung $6_n$ mit Momentanwerten $v_{b,n}[k]$ eines zweiten Rauschsignals gespeist, wobei die beiden Rauschsignale voneinander unabhängige diskrete weisse Gauss'sche Rauschsignale sind, die einen Mittelwert Null und eine Varianz $\sigma^2_{v,n}$ besitzen. Die Ausgänge der $L + 1$ Schaltungen $6_n$ sind je auf einen Eingang eines für alle Schaltungen $6_n$ gemeinsamen Addierers 7a geführt, dessen Ausgang seinerseits mit einem ersten Eingang eines weiteren Addierers 7b verbunden ist. Ein zweiter Eingang des weiteren Addierers 7b wird von Momentanwerten $w[k]$ des Rauschsignals $w[t]$ gespeist, während der Ausgang des weiteren Addierers 7b einen Ausgang des Signalsmodells bildet, an dem die Momentanwerte $y[k]$ des Messsignals $y[t]$ erscheinen.

Mit $n = 1,2, ... ,L$ gelten dann für die dynamischen Signalmodelle folgende Gleichungen eines "Random walk"-Modells

$$a_0[k + 1] = a_0[k] + v_{a,0}[k] \quad \text{(VIII)}$$
$$a_n[k + 1] = a_n[k] + v_{a,n}[k] \quad \text{(IX)}$$
$$b_n[k + 1] = b_n[k] + v_{b,n}[k] \quad \text{(X)}$$

und für die Momentanwerte $y[k]$ des Messsignals $y[t]$ die Gleichung

$$y[k] = a_0[k] + \Sigma\{a_n[k].\cos(\Omega_n.k.T) + b_n[k].\sin(\Omega_n.k.T)\} + w[k] \quad \text{(XI)},$$

wobei $\Sigma\{...\}$ diesmal die Summe der Termen $\{...\}$ für alle Werte von $n = 1$ bis $n = L$ ist.

Unter der Annahme, dass die Momentanwerte w[k] des Rauschsignals w[t] ebenfalls diskrete weisse Gauss'sche Rauschsignale sind und dass dessen Mittelwert Null sowie dessen Varianz $\sigma^2_w$ ist, entspricht das Signalmodell einer Standardform, die benutzt werden kann, um einen optimalen Filter zu entwerfen zwecks Ermittlung der Schätzwerte der als Zustandsvariablen betrachteten Parameter $a_n[k]$ und $b_n[k]$. Ein derartiges Filter ist in dem Sinne optimal, dass im Falle, in dem die Parameter $a_n[k]$ und $b_n[k]$ der Momentanwerte y[k] des Messsignals y(t) durch das Signalmodell erzeugt werden, der Erwartungswert der Quadrate der Schätzfehler, d. h. der Differenzen zwischen den Parametern $a_n[k]$ und $b_n[k]$ und deren Schätzwerte $a_{n,e}[k]$ bzw. $b_{n,e}[k]$ minimal ist. Die Koeffizienten des optimalen Filters sind nur von den Varianzen $\sigma^2_{v,n}$ und $\sigma^2_w$ abhängig und können "off-line" z. B. im voraus berechnet und als digitale Werte in einem Speicher, z. B. einem ROM, PROM oder RAM, abgespeichert werden. Verhalten sich die Parameter $a_n[k]$ und $b_n[k]$ der Momentanwerte y[k] des Messsignals y(t) nicht genau nach dem angenommenen Signalmodell, so ist der entworfene Filter zwar nicht mehr optimal, kann aber näherungsweise als optimaler Filter betrachtet werden.

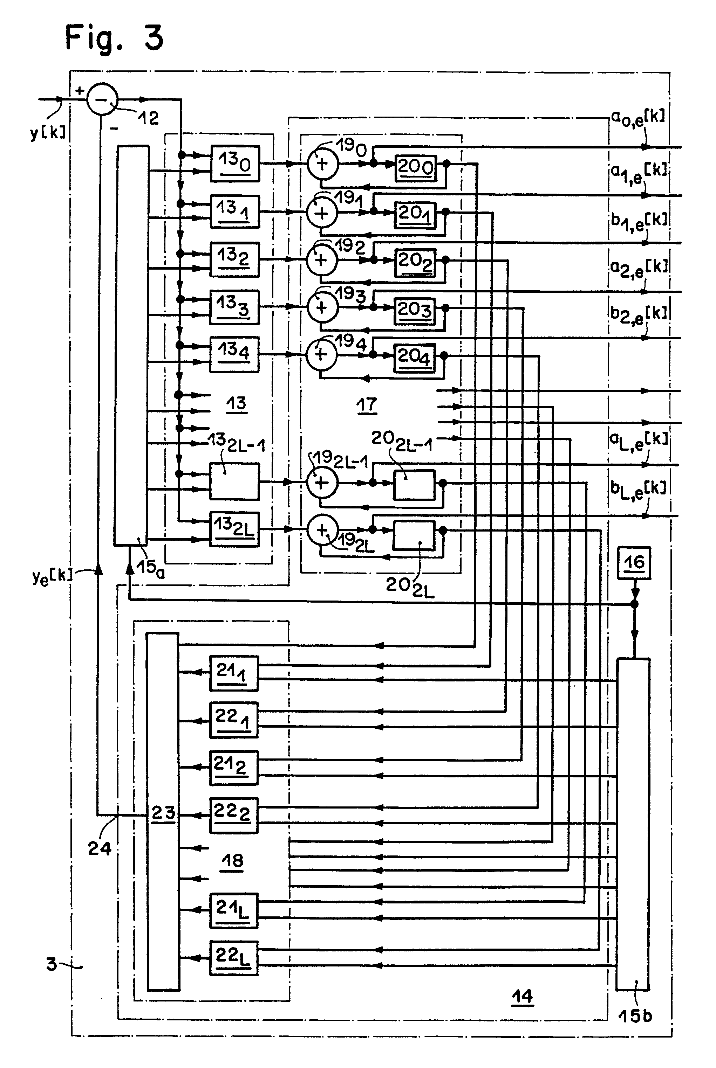

Der im obigen Sinn optimale Filter ist vorzugsweise ein Kalman-Filter, der mit einem "Random walk"-Modell entworfen ist. Der Estimator 3 besitzt in diesem Fall vorzugsweise den in der Fig. 3 dargestellten Aufbau und besteht aus einem Differenzbildner 12, einer Anordnung 13 zur Bestimmung von Korrekturschritten und einer Signalmodellschaltung 14, die in der angegebenen Reihenfolge in Kaskade geschaltet sind.

Die Anordnung 13 enthält ein Multiplikationsglied $13_0$, welches einen Multiplikationskoeffizienten $K_0[k]$ besitzt, sowie pro Wert von n = 1,2,3,...,L zwei Multiplikationsglieder $13_{2n-1}$ und $13_{2n}$, die je einen Multiplikationskoeffizienten $K_{2n-1}[k]$ bzw. $K_{2n}[k]$ aufweisen. Die Multiplikationskoeffizienten $K_0[k]$, $K_{2n-1}[k]$ und $K_{2n}[k]$ stellen Filterkoeffizienten des Kalman-Filters dar und dienen zur Gewichtung der Eingangssignale der Multiplikationsglieder $13_0$, $13_{2L-1}$ und $13_{2L}$. Sie sind zeitvariabel und nach Abklingen einer transienten Phase periodisch. Untersuchungen zeigen, dass sie im Falle, dass mit $\Omega_n$ die Kreisfrequenzen eines Grundwellensignals und dessen Oberwellensignale bezeichnet werden, folgende Form besitzen:

$$K_0[k] = B_0 \qquad (XII)$$
$$K_{2n}[k] = B_n \cdot \sin(\Omega_n kT + \theta_{2n}) \qquad (XIII)$$
$$K_{2n-1}(k) = B_n \cdot \sin(\Omega_n kT + \theta_{2n-1}) \qquad (XIV)$$

mit n = 1,2,...,L, wobei $\theta_{2n}$ und $\theta_{2n-1}$ Phasenwinkel darstellen.

Diskrete Momentanwerte dieser Multiplikationskoeffizienten $K_0[k]$, $K_{2n-1}[k]$ und $K_{2n}[k]$ können dabei, wie bereits angedeutet, im voraus "off-line" berechnet und bei digital arbeitenden Estimatoren 3 in einem Speicher 15a gespeichert werden, aus dem sie vorzugsweise mit Hilfe eines Computers 16, der z. B. ein Mikrocomputer ist, im richtigen Augenblick abgerufen und im zugehörigen Multiplikationsglied $13_0$, $13_{2L-1}$ oder $13_{2L}$ als Multiplikationskoeffizienten gespeichert werden können. Zu diesem Zweck sind jeweils Daten-Ausgänge des Speichers 15a mit ersten Eingängen der Multiplikationsglieder $13_0$, $13_{2L-1}$ oder $13_{2L}$ verbunden.

Die Anordnung 13 enthält total 2L + 1 Multiplikationsglieder $13_0$, $13_1$, ... , $13_{2L-1}$ und $13_{2L}$, die je einen ersten und einen zweiten Eingang sowie je einen Ausgang besitzen. Die zweiten Eingänge der 2L + 1 Multiplikationsglieder sind miteinander verbunden und bilden den Eingang der Anordnung 13, der seinerseits mit dem Ausgang des Differenzbildners 12 verbunden ist. Die Ausgänge der 2L + 1 Multiplikationsglieder bilden dagegen 2L + 1 Ausgänge der Anordnung 13 und sind je auf einen von 2L + 1 Eingänge der Signalmodellschaltung 14 geführt.

Die Signalmodellschaltung 14 enthält ein aus dem "Random walk" [siehe Gleichungen (VIII) bis (X)] stammendes dynamisches Signalmodell und besteht vorzugsweise aus einer Gruppenanordnung 17 von diskreten und nachfolgend Summatoren genannten Integratoren sowie einer Anordnung 18 zur Erzeugung von "Ein Schritt"-Voraussagewerten $y_e[k]$ des Messsignals y[t] auf Grund von Messungen des Messsignals y[t] bis zum Zeitpunkt k-1.

Die Gruppenanordnung 17 enthält $2_{L+1}$ Summatoren $19_0;20_0$ bis $19_{2L};20_{2L}$, die je aus einem Addierer $19_0$, $19_1$, ... , $19_{2L-1}$ bzw. $19_{2L}$ und einem zugehörigen nachgeschalteten Speicher $20_0$, $20_1$, ... , $20_{2L-1}$ bzw. $20_{2L}$ bestehen, wobei jedem der 2L + 1 Multiplikationsglieder $13_0$ bis $13_{2L}$ der Anordnung 13 in der Gruppenanordnung 17 eines der 2L + 1 Summatoren $19_0;20_0$, $19_1;20_1$, ... , $19_{2L-1};20_{2L-1}$ oder $19_{2L};20_{2L}$ zugeordnet ist. Die Gruppenanordnung 17 enthält somit total 2L + 1 Addierer $19_0$ bis $19_{2L}$ und 2L + 1 Speicher $20_0$ bis $20_{2L}$. In jedem Summator $19_0;20_0,19_1$; $20_1$, ... $,19_{2L-1};20_{2L-1}$ und $19_{2L};20_{2L}$ wird dessen Eingang, der auch einer von den 2L + 1 Eingängen der Gruppenanordnung 17 ist, durch einen ersten Eingang des zugehörigen Addierers $19_0$, $19_1$, ... , $19_{2L-1}$ bzw. $19_{2L}$ gebildet, dessen Ausgang über den zugehörigen Speicher $20_0$, $20_1$, ... , $20_{2L-1}$ bzw. $20_{2L}$ mit einem Ausgang des Summators $19_0;20_0$, $19_1$; $20_1$, ... , $19_{2L-1};20_{2L-1}$ bzw. $19_{2L};20_{2L}$ verbunden ist, der gleichzeitig ein Ausgang einer ersten Gruppe von 2L + 1 Ausgängen der Gruppenanordnung 17 ist. Der Ausgang der Speicher $20_0$ bis $20_{2L}$ ist ausserdem jeweils mit einem zweiten Eingang des zugehörigen Addierers $19_0$, $19_1$, ... , $19_{2L-1}$ bzw. $19_{2L}$ verbunden. Die Ausgänge der 2L + 1 Addierer

$19_0$ bis $19_{2L}$ sind ausserdem noch auf 2L+1 Ausgänge einer zweiten Gruppe von 2L+1 Ausgängen der Gruppenanordnung 17 geführt, die gleichzeitig 2L+1 Ausgänge der Signalmodellschaltung 14 und 2L+1 Ausgänge des Estimators 3 sind. Die 2L+1 Eingänge der Gruppenanordnung 17 sind gleichzeitig auch 2L+1 Eingänge der Signalmodellschaltung 14. Die 2L+1 Ausgänge der ersten Gruppe von Ausgängen der Gruppenanordnung 17 sind innerhalb der Signalmodellschaltung 14 noch je mit einem von 2L+1 Eingängen der Anordnung 18 verbunden.

Zu jedem Multiplikationsglied $13_{2n-1}$ der Anordnung 13 gehört in der Anordnung 18 ein $\cos(kT\Omega_n)$-Multiplikationsglied $21_n$ und zu jedem Multiplikationsglied $13_{2n}$ der Anordnung 13 ein $\sin(kT\Omega_n)$-Multiplikationsglied $22_n$, mit n = 1,2,3, ... ,L, wobei der Ausgang eines jeden dieser Multiplikationsglieder $13_{2n-1}$ bzw. $13_{2n}$ jeweils über den zugehörigen Summator der Gruppenanordnung 17 mit einem ersten Eingang des zugehörigen $\cos(kT\Omega_n)$- bzw. $\sin(kT\Omega_n)$-Multiplikationsgliedes $21_n$ bzw. $22_n$ verbunden ist. Die Übertragungsfaktoren der Multiplikationsglieder $21_n$ und $22_n$ sind jeweils $\cos(kT\Omega_n)$ bzw. $\sin(kT\Omega_n)$, deren Werte bei einem digital arbeitenden Estimator 3 vorzugsweise als digitale Werte in einem weiteren Speicher 15b gespeichert sind. Der Computer 16 ruft dann diese digitalen Werte im richtigen Augenblick ab, um sie im zugehörigen Multiplikationsglied $21_n$ bzw. $22_n$ zu speichern. Zu diesem Zweck sind Daten-Ausgänge des weiteren Speichers 15b jeweils mit zweiten Eingängen der $\cos(kT\Omega_n)$- bzw. $\sin(kT\Omega_n)$-Multiplikationsglieder $21_n$ bzw. $22_n$ verbunden. Die beiden Speicher 15a und 15b bilden in der Praxis zusammen vorzugsweise einen einzigen Speicher 15a;15b, der z. B. ein ROM, ein PROM oder ein RAM ist. Die Speicher 15a, 15b bzw. 15a;15b und der sie steuernde Computer 16 sind vorzugsweise im Estimator 3 enthalten. Ausgänge des Computers 16 sind dabei jeweils mit Adressen-Eingängen der beiden Speicher 15a und 15b bzw. des Speichers 15a;15b verbunden. Der Ausgang des Speichers $20_0$ der Gruppenanordnung 17 und die Ausgänge aller $\cos(kT\Omega_n)$- und $\sin(kT\Omega_n)$-Multiplikationsglieder $21_n$ und $22_n$ sind je auf einen von 2L+1 Eingänge eines gemeinsamen weiteren Addierers 23 geführt, der in der Anordnung 18 enthalten ist und dessen Ausgang einen Ausgang der Anordnung 18 bildet. Der Ausgang der Anordnung 18 bildet seinerseits einen zusätzlichen Ausgang 24 der Signalmodellschaltung 14, der seinerseits mit einem Minus-Eingang des Differenzbildners 12 verbunden ist, während der Plus-Eingang des letzteren einen Eingang des Estimators 3 bildet.

Wenn die Parameter $a_n[k]$ und $b_n[k]$ der Momentanwerte y[k] des Messsignals y(t) mittels des durch die Gleichungen (VIII) bis (X) beschriebenen Signalmodells erzeugt werden, dann muss der Estimator 3 mit n = 1,2, ... ,L folgende Gleichungen verwirklichen:

$$a_{0,e}[k] = a_{0,e}[k-1] + K_0[K].(y[k]-y_e[k]) \quad \text{(XV)}$$
$$a_{n,e}[k] = a_{n,e}[k-1] + K_{2n-1}[k].(y[k]-y_e[k]) \quad \text{(XVI)}$$
$$b_{n,e}[k] = b_{n,e}[k-1] + K_{2n}[k] .(y[k]-y_e[k]) \quad \text{(XVII)}$$
$$y_e[k] = a_{0,e}[k-1] + \Sigma\{a_{n,e}[k-1].\cos(\Omega_n kT) + b_{n,e}[k-1].\sin(\Omega_n kT)\} \quad \text{(XVIII)},$$

wobei $\Sigma$ die Summe für alle Werte von n = 1 bis N = L bezeichnet.

Zu Beginn des Verfahrens sind in den 2L+1 Speichern $20_0$ bis $20_{2L}$ beliebige, nach Möglichkeit wahrscheinliche Werte der Schätzwerte $a_{0,e}[k-1]$, $a_{n,e}[k-1]$ und $b_{n,e}[k-1]$, z. B. Nullwerte, gespeichert.

Besitzt die Anordnung den in den Figuren 1 und 3 dargestellten Aufbau, dann werden zeitlich nacheinander im Estimator 3 aus momentanen geltenden, in den Speichern $20_0$ bis $20_{2L}$ gespeicherten Schätzwerten $a_{0,e}[k-1]$, $a_{n,e}[k-1]$ und $b_{n,e}[k-1]$ der Momentanwerte $a_0[k-1]$, $a_n[k-1]$ und $b_n[k-1]$ der Fourier-Koeffizienten über eine zeitabhängige periodische Rückkopplung "Ein Schritt"-Voraussagewerte $y_e[k]$ des Messsignals y[t] erzeugt und im Differenzbildner 12 mit den gemessenen Momentanwerten y[k] des Messsignals y[t] verglichen, indem dort zeitlich nacheinander Differenzsignale $y[k]-y_e[k]$ zwischen gemessenen Momentanwerten $y[k]$ und "Ein Schritt"-Voraussagewerte $y_e[k]$ des Messsignals y[t] erzeugt werden. Zur Berechnung der "Ein Schritt"-Voraussagewerte $y_e[k]$ des Messsignals y[t] werden die in den Speichern $20_0$ bis $20_{2L}$ gespeicherten Schätzwerte $a_{0,e}[k-1]$, $a_{n,e}[k-1]$ und $b_{n,e}[k-1]$ der Momentanwerte $a_0[k-1]$, $a_n[k-1]$ und $b_n[k-1]$ der Fourier-Koeffizienten in der Anordnung 18 mit den Sinus- und Cosinusfunktionen $\sin(kT\Omega_n)$ bzw. $\cos(kT\Omega_n)$ multipliziert und anschliessend mittels des Addierers 23 addiert. Die z. B. digitalen Werte dieser Sinus- und Cosinusfunktionen wurden dabei im richtigen Augenblick kurz vorher durch den Computer 16 aus dem Speicher 15b bzw. 15a;15b abgerufen und in den $\sin(kT\Omega_n)$- bzw. $\cos(kT\Omega_n)$-Multiplikationsgliedern $21_n$ bzw. $22_n$ gespeichert. Die Differenzsignale $y[k]-y_e[k]$ dienen dann dazu, zeitlich nacheinander die in den Speichern $20_0$ bis $20_{2L}$ gespeicherten Schätzwerten $a_{0,e}[k-1]$, $a_{n,e}[k-1]$ und $b_{n,e}[k-1]$ der Momentanwerte $a_0[k-1]$, $a_n[k-1]$ und $b_n[k-1]$ der Fourier-Koeffizienten schrittweise zu korrigieren. Zu diesem Zweck wird zeitlich nacheinander jedes Differenzsignal $y[k]-y_e[k]$ zuerst einmal in der Anordnung 13 des Estimators 3 mit den zeitvariablen Multiplikationskoeffizienten $K_0[k]$, $K_{2n-1}[k]$ und $K_{2n}[k]$ gewichtet, indem es mit diesen zeitvariablen Multiplikationskoeffizienten multipliziert wird, deren z. B. digitale Werte im Speicher 15a bzw. 15a;15b gespeichert sind und im richtigen Augenblick kurz vorher durch den Computer 16 aus dem Speicher 15a bzw. 15a;15b abgerufen und in den Multiplikationsgliedern $13_0$ bis $13_{2L}$ abgespeichert wurden. Aus den gewichteten Differenzsignalen werden anschliessend zeitlich nacheinander mittels der Summatoren $19_0;20_0$ bis $19_{2L};20_{2L}$ neugeltende Werte der Schätzwerte $a_{0,e}[k]$, $a_{n,e}[k]$ und $b_{n,e}[k]$ der Momentanwerte $a_0[k]$, $a_n[k]$ und $b_n[k]$ der Fourier-Koeffizienten ermittelt und in den Speichern $20_0$ bis $20_{2L}$ gespeichert.

Aus den im Estimator 3 ermittelten Schätzwerten $a_{0,e}[k]$, $a_{n,e}[k]$ und $b_{n,e}[k]$ der Momentanwerte $a_0[k]$, $a_n[k]$ und $b_n[k]$ der Fourier-Koeffizienten werden dann ggf. noch anschliessend mittels der Nachverarbeitungsanordnung 4;5 Schätzwerte $A_{0,e}[kT_s]$, $A_{n,e}[kT_s]$ und $\Phi_{n,e}[kT_s]$ des abgetasteten "Gleichspannungsterms" und der abgetasteten Amplituden und Phasen der sinusförmigen Signale ermittelt.

Der Estimator 3 kann auch auf der Methode der kleinsten Quadrate mit exponentiellem Vergessen beruhen.

Die erfindungsgemässe Anordnung kann auch in analoger Weise arbeiten. In diesem Fall sind die Abtastschaltung 1 und der Analog/Digital-Wandler 1a nicht vorhanden und sind für die andern Bauelemente Analogschaltungen zu verwenden.

## Patentansprüche

1. Verfahren zur Ermittlung von Schätzwerten ($a_{0,e}[k]$, $a_{n,e}[k]$, $b_{n,e}[k]$ bzw. $A_{0,e}[k]$, $A_{n,e}[k]$, $\Phi_{n,e}[k]$) der Momentanwerte ($a_0[k]$, $a_n[k]$, $b_n[k]$ bzw. $A_0[k]$, $A_n[k]$, $\Phi_n[k]$) von Parametern ($a_0[t]$, $a_n[t]$, $b_n[t]$ bzw. $A_0[t]$, $A_n[t]$, $\Phi_n[t]$) mindestens eines sinusförmigen Signals mit konstanter und vorbekannter Frequenz ($\Omega_n$), welches ein additiver Teil eines Messsignals ($y[t]$) ist, dessen gemessene Momentanwerte ($y[k]$) zu diskreten Zeitpunkten ($t_K$, kT, k) zur Verfügung stehen, dadurch gekennzeichnet, dass zeitlich nacheinander Schätzwerte ($a_{0,e}[k]$, $a_{n,e}[k]$, $b_{n,e}[k]$) der Momentanwerte ($a_0[k]$, $a_n[k]$, $b_n[k]$) von Fourier-Koeffizienten mindestens zweier gesuchter sinusförmiger Signale, die verschiedene, zum voraus bekannte Frequenzen ($\Omega_n$) besitzen, ermittelt und gespeichert werden, dass aus gespeicherten Schätzwerten ($a_{0,e}[k-1]$, $a_{n,e}[k-1]$, $b_{n,e}[k-1]$) von Momentanwerten ($a_0[k-1]$, $a_n[k-1]$, $b_n[k-1]$) der Fourier-Koeffizienten zeitlich nacheinander "Ein Schritt"-Voraussagewerte ($y_e[k]$) des Messsignals ($y[t]$) erzeugt werden, und dass zeitlich nacheinander Differenzsignale ($y[k]-y_e[k]$) zwischen gemessenen Momentanwerten ($y[k]$) und "Ein Schritt"-Voraussagewerten ($y_e[k]$) des Messsignals ($y[t]$) erzeugt werden, die dazu dienen, zeitlich nacheinander die gespeicherten Schätzwerte ($a_{0,e}[k-1]$, $a_{n,e}[k-1]$, $b_{n,e}[k-1]$) der Momentanwerte

($a_0[k-1]$, $a_n[k-1]$, $b_n[k-1]$) der Fourier-Koeffizienten schrittweise zu korrigieren.

2. Verfahren nach Anspruch 1, dadurch gekennzeichnet, dass zum Korrigieren der gespeicherten Schätzwerte ($a_{0,e}[k-1]$, $a_{n,e}[k-1]$, $b_{n,e}[k-1]$) der Momentanwerte ($a_0[k-1]$, $a_n[k-1]$, $b_n[k-1]$) der Fourier-Koeffizienten ein statistisches Verfahren verwendet wird.

3. Verfahren nach Anspruch 2, dadurch gekennzeichnet, dass zum Korrigieren der gespeicherten Schätzwerte ($a_{0,e}[k-1]$, $a_{n,e}[k-1]$, $b_{n,e}[k-1]$) der Momentanwerte ($a_0[k-1]$, $a_n[k-1]$, $b_n[k-1]$) der Fourier-Koeffizienten jedes Differenzsignal ($y[k]-y_e[k]$) zuerst einmal mit zeitvariablen Multiplikationskoeffizienten ($K_0[k]$, $K_{2n-1}[k]$, $K_{2n}[k]$) gewichtet wird, indem es mit den zeitvariablen Multiplikationskoeffizienten ($K_0[k]$, $K_{2n-1}[k]$, $K_{2n}[k]$) multipliziert wird.

4. Verfahren nach Anspruch 3, dadurch gekennzeichnet, dass aus den gewichteten Differenzsignalen mittels Summatoren ($19_0;20_0$ bis $19_{2L};20_{2L}$) neugeltende Werte der Schätzwerte ($a_{0,e}[k]$, $a_{n,e}[k]$, $b_{n,e}[k]$) der Momentanwerte ($a_0[k]$, $a_n[k]$, $b_n[k]$) der Fourier-Koeffizienten ermittelt und gespeichert werden.

5. Verfahren nach einem der Ansprüche 1 bis 4, dadurch gekennzeichnet, dass die "Ein Schritt"-Voraussagewerte ($y_e[k]$) des Messsignals ($y[t]$) durch Multiplikation der gespeicherten Schätzwerte ($a_0[k-1]$, $a_{n,e}[k-1]$, $b_{n,e}[k-1]$) der Momentanwerte ($a_0[k-1]$, $a_n[k-1]$, $b_n[k-1]$) der Fourier-Koeffizienten mit Sinus- und Cosinusfunktionen und anschliessender Addition berechnet werden.

6. Verfahren nach einem der Ansprüche 1 bis 5, dadurch gekennzeichnet, dass die Schätzwerte ($a_{0,e}[k]$, $a_{n,e}[k]$, $b_{n,e}[k]$) der Momentanwerte ($a_0[k]$, $a_n[k]$ $b_n[k]$) der Fourier-Koeffizienten gefiltert werden.

7. Verfahren nach einem der Ansprüche 1 bis 6, dadurch gekennzeichnet, dass aus den nichtgefilterten oder gefilterten Schätzwerten ($a_{0,e}[k]$, $a_{n,e}[k]$, $b_{n,e}[k]$ bzw. $a_{0,e,m}[kT_s]$, $a_{n,e,m}[kT_s]$, $b_{n,e,m}[kT_s]$) der Momentanwerte ($a_0[k]$, $a_n[k]$, $b_n[k]$) der Fourier-Koeffizienten Schätzwerte ($A_{0,e}[k]$, $A_{n,e}[k]$, $\Phi_{n,e}[k]$) der Momentanwerte ($A_0[k]$, $A_n[k]$, $\Phi_n[k]$) der Amplituden und/oder Phasen der gesuchten sinusförmigen Signale mittels einer nichtlinearen Transformation ermittelt werden.

8. Anordnung zur Durchführung des Verfahrens nach einem der Ansprüche 1 bis 7, dadurch gekennzeichnet, dass zur Ermittlung und Speicherung der Schätzwerte ($a_{0,e}[k]$, $a_{n,e}[k]$, $b_{n,e}[k]$) der Momentanwerte ($a_0[k]$, $a_n[k]$, $b_n[k]$) der Fourier-Koeffizienten ein Estimator (3) vorhanden ist.

9. Anordnung nach Anspruch 8, dadurch gekennzeichnet, dass der Estimator (3) ein Kalman-Filter ist, der mit einem "Random walk"-Modell entworfen ist.

10. Anordnung nach Anspruch 9, dadurch gekennzeichnet, dass der Kalman-Filter aus einem Differenzbildner (12) zur Erzeugung der Differenzsignale ($y[k]-y_e[k]$), einer Anordnung (13) zur Bestimmung von Korrekturschritten und einer Signalmodellschaltung (14) besteht, die in der angegebenen Reihenfolge in Kaskade geschaltet sind, und dass ein Ausgang (24) der Signalmodellschaltung (14) mit einem Minus-Eingang des Differenzbildners (12) verbunden ist, dessen Plus-Eingang einen Eingang des Kalman-Filters bildet.

11. Anordnung nach Anspruch 10, dadurch gekennzeichnet, dass die Anordnung (13) zur Bestimmung von Korrekturschritten Multiplikationsglieder ($13_0$ $13_1$,...,$13_{2L}$) enthält zum Multiplizieren der Differenzsignale ($y[k]-y_e[k]$) mit zeitvariablen Multiplikationskoeffizienten ($K_0[k]$, $K_{2n-1}[k]$, $K_{2n}[k]$).

12. Anordnung nach Anspruch 10 oder 11, dadurch gekennzeichnet, dass die Signalmodellschaltung (14) aus einer Gruppenanordnung (17) von Summatoren ($19_0;20_0$, $19_1;20_1$,...,$19_{2L};20_{2L}$) zur Ermittlung und Speicherung von neugeltenden Werten der Schätzwerte ($a_{0,e}[k]$, $a_{n,e}[k]$, $b_{n,e}[k]$) der Momentanwerte ($a_0[k]$, $a_n[k]$, $b_n[k]$) der Fourier-Koeffizienten und einer Anordnung (18) zur Erzeugung von "Ein Schritt"-Voraussagewerten ($y_e[k]$) des Messsignals ($y[t]$) besteht.

13. Anordnung nach Anspruch 12, dadurch gekennzeichnet, dass die Summatoren ($19_0;20_0$, $19_1;20_1$,...,$19_{2L};20_{2L}$) je aus einem Addierer ($19_0$, $19_1$,...,$19_{2L}$) und einem zugehörigen nachgeschalteten Speicher ($20_0$, $20_1$,...,$20_{2L}$) bestehen, dass die nachgeschalteten Speicher ($20_0$, $20_1$,...,$20_{2L}$) der Speicherung der Schätzwerte ($a_{0,e}[k]$, $a_{n,e}[k]$, $b_{n,e}[k]$) der Momentanwerte ($a_0[k]$, $a_n[k]$, $b_n[k]$) der Fourier-Koeffizienten dienen und dass der Ausgang der nachgeschalteten Speicher ($20_0$ $20_1$,...,$20_{2L}$) jeweils mit einem Eingang des zugehörigen Addierers ($19_0$, $19_1$,...,$19_{2L}$) verbunden ist.

14. Anordnung nach Anspruch 12 oder 13, dadurch gekennzeichnet, dass die Anordnung (18) zur Erzeugung von rekonstruierten Momentanwerten ($y_e[k]$) des Messsignals ($y[t]$) $\cos(kT\Omega_n)$-Multiplikationsglieder ($21_1,21_2,...,21_L$) und $\sin(kT\Omega_n)$-Multiplikationsglieder ($22_1,22_2,...,22_L$) enthält, deren Ausgänge auf Eingänge eines gemeinsamen weiteren Addierers (23) geführt sind, dessen Ausgang seinerseits den Ausgang (24) der Signalmodellschaltung (14) bildet, der mit dem Minus-Eingang des Differenzbildners (12) verbunden ist.

15. Anordnung nach einem der Ansprüche 8 bis 14, dadurch gekennzeichnet, dass eine Abtastschaltung (1) am Eingang der Anordnung vorhanden ist zur Abtastung des Messsignals ($y[t]$) zwecks Erzeugung von dessen zu diskreten Zeitpunkten zur Verfügung stehenden Momentanwerten ($y[k]$) und dass eine nachgeschaltete Speicherschaltung (2) vorhanden ist zur Speicherung der Momentanwerte ($y[k]$) des Messsignals ($y[t]$).

16. Anordnung nach Anspruch 15, dadurch gekennzeichnet, dass zwischen der Abtastschaltung (1) und der Speicherschaltung (2) ein Analog/Digital-Wandler (1a) angeordnet ist und dass digitale Werte der zeitvariablen Multiplikationskoeffizienten ($K_0[k]$, $K_{2n-1}[k]$, $K_{2n}[k]$) in einem Speicher (15a bzw. 15a;15b) gespeichert sind, der von einem Computer (16) gesteuert ist.

17. Anordnung nach einem der Ansprüche 8 bis 16, dadurch gekennzeichnet, dass dem Estimator (3) ein Tiefpassfilter (4) nachgeschaltet ist zur Filterung der Schätzwerte ($a_{0,e}[k]$, $a_{n,e}[k]$, $b_{n,e}[k]$) der Momentanwerte ($a_0[k]$, $a_n[k]$, $b_n[k]$) der Fourier-Koeffizienten.

18. Anordnung nach einem der Ansprüche 8 bis 17, dadurch gekennzeichnet, dass am Ausgang der Anordnung eine Transformationsschaltung (5) angeordnet ist zur nichtlinearen Transformation der nichtgefilterten oder gefilterten Schätzwerte ($a_{0,e}[k]$, $a_{n,e}[k]$, $b_{n,e}[k]$ bzw. $a_{0,e,m}[k]$, $a_{n,e,m}[k]$, $b_{n,e,m}[k]$) der Momentanwerte ($a_0[k]$, $a_n[k]$ $b_n[k]$) der Fourier-Koeffizienten in Schätzwerte ($A_{0,e}[k]$, $A_{n,e}[k]$, $\Phi_{n,e}[k]$) der Momentanwerte ($A_0[k]$, $A_n[k]$, $\Phi_n[k]$) von Amplituden und/oder Phasen der gesuchten sinusförmigen Signale.

19. Verwendung des Verfahrens nach einem der Ansprüche 1 bis 7 oder der Anordnung nach einem der Ansprüche 8 bis 18 zur Bestimmung von Werten einer elektrischen Wirkleistung und/oder Blindleistung und/oder Scheinleistung und/oder von Effektivwerten von Strömen und/oder von elektrischen Spannungen.

20. Verwendung des Verfahrens nach einem der Ansprüche 1 bis 7 oder der Anordnung nach einem der Ansprüche 8 bis 18 zur Bestimmung von Werten einer elektrischen Wirkenergie und/oder Blindenergie und/oder Scheinenergie und/oder von Effektivwerten von Strömen und/oder von elektrischen Spannungen.

21. Verwendung des Verfahrens nach einem der Ansprüche 1 bis 7 oder der Anordnung nach einem der Ansprüche 8 bis 18 zur Detektion von Rundsteuerungssignalen.

22. Verwendung des Verfahrens nach einem der Ansprüche 1 bis 7 oder der Anordnung nach einem der Ansprüche 8 bis 18 zur gleichzeitigen Bestimmung von Rundsteuerungssignalen sowie einer elektrischen Wirkleistung und/oder Blindleistung und/oder Scheinleistung.

23. Verwendung des Verfahrens nach einem der Ansprüche 1 bis 7 oder der Anordnung nach einem der Ansprüche 8 bis 18 zur gleichzeitigen Bestimmung von Rundsteuerungssignalen sowie einer elektrischen Wirkenergie und/oder Blindenergie und/oder Scheinenergie.

EP 0 454 946 A1

**Fig. 1**

1/2

**Fig. 2**

11

# Fig. 3

Europäisches
Patentamt

**EUROPÄISCHER
RECHERCHENBERICHT**

Nummer der Anmeldung

**EP 91 10 0885**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | PATENT ABSTRACTS OF JAPAN, Band 13, Nr. 571 (E-862), 18. Dezember 1989; & JP-A-01 238 416 (MITSUBISHI ELECTRIC CORP.) 22-09-1989 − − − | 1 | G 01 R 19/00 |
| Y | EP-A-0 218 220 (NIAGARA MOHAWK) * Page 95; Figur 30 * − − − | 1 | |
| A | EP-A-0 002 790 (SIEMENS) − − − | | |
| A | DE-A-3 733 555 (HARTMANN & BRAUN) − − − − − | | |

| | RECHERCHIERTE SACHGEBIETE (Int. Cl.5) |
|---|---|
| | G 01 R |

**Der vorliegende Recherchenbericht wurde für alle Patentansprüche erstellt**

| Recherchenort | Abschlußdatum der Recherche | Prüfer |
|---|---|---|
| Den Haag | 26 Juni 91 | HOORNAERT W. |